(19) Europäisches Patentamt / European Patent Office / Office européen des brevets

(11) **EP 2 593 754 B1**

(12) **EUROPÄISCHE PATENTSCHRIFT**

(45) Veröffentlichungstag und Bekanntmachung des Hinweises auf die Patenterteilung:
**25.05.2016   Patentblatt 2016/21**

(21) Anmeldenummer: **11748596.1**

(22) Anmeldetag: **11.07.2011**

(51) Int Cl.:
*G01D 3/08* (2006.01)     *G01D 5/252* (2006.01)
*B60Q 1/14* (2006.01)     *H01H 1/00* (2006.01)
*H03K 17/00* (2006.01)

(86) Internationale Anmeldenummer:
**PCT/EP2011/061780**

(87) Internationale Veröffentlichungsnummer:
**WO 2012/007436 (19.01.2012 Gazette 2012/03)**

(54) **VERFAHREN ZUR ERFASSUNG EINER SCHALTSTELLUNG EINER SCHALTEINRICHTUNG**

METHOD OF DETECTING A SWITCHING POSITION OF A SWITCHING DEVICE

PROCÉDÉ DE DÉTECTION D'UNE POSITION DE COMMUTATION D'UN DISPOSITIF DE COMMUTATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2010   DE 102010026919**

(43) Veröffentlichungstag der Anmeldung:
**22.05.2013   Patentblatt 2013/21**

(73) Patentinhaber: **Leopold Kostal GmbH & Co. KG**
**58513 Lüdenscheid (DE)**

(72) Erfinder:
• **WAGNER, Martin**
  **58509 Lüdenscheid (DE)**
• **BÜHLMANN, Rainer**
  **59439 Holzwickede (DE)**
• **THORMANN, Werner**
  **58553 Halver (DE)**
• **KOBER, Sven**
  **53127 Bonn (DE)**
• **KATHOL, Meinolf**
  **57413 Finnentrop (DE)**

(74) Vertreter: **Kerkmann, Detlef**
**Leopold Kostal GmbH & Co. KG**
**Rechte & Patente**
**An der Bellmerei 10**
**58513 Lüdenscheid (DE)**

(56) Entgegenhaltungen:
DE-A1-102008 007 650     DE-A1-102008 044 115
DE-T2- 69 401 403     US-A- 5 621 398

**EP 2 593 754 B1**

## Beschreibung

Die Erfindung betrifft ein Verfahren zur Erfassung einer Schaltstellung einer zumindest ein Schaltelement umfassenden Schalteinrichtung, wobei die jeweilige Schaltstellung des Schaltelements durch einen Wert einer physikalischen Messgröße des Schaltelements repräsentiert ist, die über einen A/D-Wandlereingang einem Mikroprozessor zur Auswertung zugeführt wird.

Derartige Schalteinrichtungen werden beispielsweise in Kraftfahrzeugen eingesetzt, um verschiedene Fahrzeugfunktionen anzusteuern. So ist es z.B. üblich eine mehrere Einzelschalter umfassende Schalteinrichtung in einem so genannten Lenksäulenmodul für ein Kraftfahrzeug zu integrieren. Die Einzelschalter sind dabei beispielsweise zur Steuerung der Scheibenwisch- und waschanlage, der Blinker und der Fernlichtumschaltung des Fahrzeugs vorgesehen.

Die DE 10 2008 044 115 A1 zeigt Verfahren zur Erkennung einer Schalterstellung von Schaltern in einer Mehrzahl von Schaltelementen, wobei ein Eindraht-Bussystem verwendet wird, bei dem die Schaltelemente in einer Art Spannungsteilerschaltung in Reihe geschaltet angeordnet sind.

Die DE 10 2008 007 650 A1 zeigt Verfahren zur Erkennung einer Schalterstellung von zwei mechanisch miteinander gekoppelten Schaltelementen, die in ihren vorgesehenen Betriebsstellungen gleichzeitig und gleichsinnig betätigt sind. Diesen beiden Schaltzuständen sind vorgegebene feste Sollwerte zugeordnet, mit denen Ist-Werte der gemessenen Spannung zur Identifizierung des jeweils vorliegenden Schaltzustandes verglichen werden. Ein Fehler im mechanischen Teil der Schaltanordung wird hier dadurch erkannt, dass einer der beiden Schalter offen und der andere gleichzeitig geschlossen ist. Dies führt zu Ist-Werten der gemessenen Spannung, denen ebenfalls (andere) vorgegebene feste Sollwerte zugeordnet sind. Diese Werte zeigen jedoch in diesem Falle den mechanischen Fehler an.

In der einzigen Figur ist ein Ersatzschaltbild einer zur Durchführung des erfindungsgemäßen Verfahrens vorgesehenen Schalteinrichtung gezeigt, bei der es sich um ein mehrere Schaltelemente umfassendes Lenksäulenmodul für ein Kraftfahrzeug, wie zuvor beschrieben, handelt. Bei diesem sind die Schaltelemente den genannten Fahrzeugfunktionen zugeordnet. Jedes der Schaltelemente SE1, SE2 (hier sind beispielhaft nur zwei Schaltelemente dargestellt, wobei die tatsächliche Ausführung natürlich mehr aufweisen kann) umfasst dabei einen Messwiderstand M1, M2, der mit seinem einen Anschluss mit einem Massepotential Gnd verbunden ist. Der andere Anschluss des Messwiderstands M1, M2 wird in jeder Schaltstellung über einen dieser Schaltstellung jeweils zugeordneten Schaltwiderstand S11, S12, S13; S21, S22, S23, S24 mit einer konstanten Versorgungsspannung Vcc verbunden. Die Anzahl der in den Schaltelementen SE1., SE2 jeweils vorhandenen Schaltwiderstände S11, S12, S13; S21, S22, S23, S24 richtet sich nach der Anzahl der mit dem jeweiligen Schaltelement Se1 bzw. SE2 zu realisierenden Schaltstellungen, in diesem Beispiel also 3 Schaltstellungen für SE1 und 4 Schaltstellungen für SE2. Die dabei über dem Messwiderstand M1, M2 abfallende Messspannung $U_{M1}$ , $U_{M2}$ wird über einen A/D-Wandlereingang A/D 1, A/D 2 einem Mikroprozessor $\mu$C zur Auswertung zugeführt.

Die Widerstandszweige der den unterschiedlichen Funktionen zugeordneten Schaltelemente SE1, SE2 der Schalteinrichtung sind, wie in der Zeichnung zu sehen, parallel zueinander geschaltet, und mit ihren der jeweils ausgewählten Schaltstellung entsprechenden Schaltwiderständen (im dargestellten Beispiel S11, S23) durch eine gemeinsame elektrische Leitung mit der Versorgungsspannung Vcc verbunden.

Aus den bekannten Nenngrößen der Messwiderstände M1, M2, der den jeweiligen Schaltstellungen zugeordneten Schaltwiderstände S11, S12, S13; S21, S22, S23, S24 sowie der anliegenden Versorgungsspannung Vcc, die im vorliegenden Beispiel auch messtechnisch über einen A/D-Wandlereingang A/D 3 des Mikroprozessors $\mu$C mit ihrem Ist-Wert $U_{vcc}$ erfasst wird, ergeben sich vorgegebene, feste Soll-Werte für die den verschiedenen Schaltstellungen der Schaltelemente SE1, SE2 jeweils zugeordneten Spannungsabfälle über den Messwiderständen M1, M2, also den Messspannungen $U_{M1}$ , $U_{M2}$.

Aufgrund von Toleranzen der eingesetzten Bauteile sowie von Leitungswiderständen oder Übergangswiderständen an Umschaltern oder Steckverbindungen ergeben sich jedoch Abweichungen der tatsächlichen wirksamen Widerstände von den auslegungsgemäßen Nennwerten. Dieser Umstand beeinflusst die gesamte Schalteinrichtung, und kann damit zum Teil deutliche Abweichungen der tatsächlich erfassten Messspannungswerte $U_{M1}$ , $U_{M2}$ von den vorgegebenen, festen Soll-Werten hervorrufen.

Wenn die hierbei auftretenden Abweichungen die Größenordnung der Abstände zwischen den jeweils unterschiedlichen Schaltstellungen zugeordneten Messspannungen $U_{M1}$ , $U_{M2}$ erreichen, kann es zu fehlerhaften Schaltstellungsinformationen und damit zu Fehlfunktionen der mit der Schalteinrichtung betriebenen Fahrzeugeinrichtungen kommen. Grundsätzlich ist es daher wünschenswert über eine Möglichkeit zur Validierung der aus den erfassten Messspannungen $U_{M1}$ , $U_{M2}$ abgeleiteten Schaltstellungserfassung zu verfügen, um im Falle einer als potentiell fehlerbehaftet qualifizierten Schaltstellungsinformation zumindest das Auslösen der damit verbundenen und zumindest potentiell unerwünschten Fahrzeugfunktion zu unterbinden. Weiterhin wünschenswert wäre es, nach Möglichkeit sogar die fehlerhafte Schaltstellungsinformation zu korrigieren und die tatsächlich beabsichtigte Funktion auszulösen.

Eine solche Validierung einer Schaltstellungserfassung leistet das erfindungsgemäße Verfahren zur Erfassung einer Schaltstellung einer zumindest ein Schaltelement umfassenden Schalteinrichtung, wobei die jeweilige Schaltstellung des Schaltelements durch einen Wert einer physikalischen Messgröße des Schaltelements repräsentiert ist, die über einen A/D-Wandlereingang einem Mikroprozessor zur Auswertung zugeführt wird, mit den im Patentanspruch 1 angegebenen Verfahrensschritten.

Bei den in diesem Patentanspruch genannten physikalischen Messgrößen handelt es sich beispielsweise um Spannungswerte oder Stromstärkewerte, bei den Nennwerten der die Messgröße bestimmenden Bauelemente um Widerstandswerte, Kapazitätswerte oder Induktivitätswerte und bei den Eingangsgrößen der Schalteinrichtung um Versorgungsspannungswerte oder Eingangsstromstärkewerte. Die physikalische Vergleichsgröße betrifft beispielsweise einen dieser genannten Werte, der als abgeleiteter Wert aus anderen (Mess-)werten berechnet, als Nennwert vorgegeben oder als Ist-Wert durch eine aktuelle Messung erfasst sein kann.

Bevorzugt wird bei einer Qualifizierung der vorliegenden Schaltstellungserfassung als fehlerhaft das Auslösen der damit verbundenen Fahrzeugfunktion unterbunden.

Bezogen auf eine entsprechend der Zeichnung ausgeführte Form der Schalteinrichtung, die zumindest zwei Schaltelemente SE1, SE2 umfasst, welche wiederum jeweils einen Widerstandszweig mit einem Messwiderstand M1, M2 und zumindest zwei Schaltwiderständen S11, S12, S13; S21, S22, S23, S24 umfassen, wobei der eine Anschluss des Messwiderstands M1, M2 mit einem Massepotential Gnd verbunden ist und der andere Anschluss in jeder Schaltstellung über einen dieser Schaltstellung jeweils zugeordneten Schaltwiderstand S11, S12, S13; S21, S22, S23, S24 mit einer konstanten Versorgungsspannung Vcc verbunden wird, wobei die Widerstandszweige parallel zueinander geschaltet, und durch gemeinsame elektrische Leitungen einerseits mit dem Massepotential Gnd und andererseits mit der Versorgungsspannung Vcc verbunden sind, und wobei die über den Messwiderständen M1, M2 abfallenden Messspannungen $U_{M1}$, $U_{M2}$ über A/D-Wandler-eingänge A/D 1, A/D 2 einem Mikroprozessor $\mu$C zur Auswertung zugeführt werden, ist das erfindungsgemäße Verfahren in einer Ausführungsform vorgesehen, die durch die Abfolge der folgenden Verfahrensschritte charakterisiert ist:

- Erfassen der Messspannungen $U_{M1}$, $U_{M2}$ in den Widerstandszweigen der den unterschiedlichen Funktionen zugeordneten Schaltelemente SE1, SE2
- Identifizieren der jeweiligen Schaltstellungen durch Vergleich der erfassten Ist-Werte der Messspannungen $U_{M1}$, $U_{M2}$ mit vorgegebenen, festen Soll-Werten für die verschiedenen Schaltstellungen
- Berechnen der in den jeweiligen Widerstandszweigen fließenden Zweigströme I1, I2 aus den erfassten Messspannungen $U_{M1}$, $U_{M2}$ und den Nominalwerten der Messwiderstände M1, M2:

$$I1 = M1 * U_{M1} \quad ; \quad I2 = M2 * U_{M2}$$

- Addieren der in den jeweiligen Widerstandszweigen fließenden Zweigströme I1, I2 zu dem durch alle parallelen Widerstandszweige gemeinsam fließenden Gesamtstrom Iges:

$$Iges = I1 + I2$$

- Berechnen des durch die Parallelschaltung aller Widerstandszweige gebildeten Gesamtwiderstands Rges zwischen dem Massepotential Gnd und der Versorgungsspannung Vcc aus den Nominalwerten der Messwiderstände M1, M2 und der in den identifizierten Schaltstellungen wirksamen Schaltwiderstände (im dargestellten Beispiel S11, S23):

$$R1 = M1 + S11 \quad ; \quad R2 = M2 + S23 \quad ; \quad Rges = R1 * R2 / (R1 + R2)$$

- Berechnen des Gesamtspannungsabfalls Uges über der Parallelschaltung aller Widerstandszweige aus den berechneten Werten des Gesamtstroms Iges und des Gesamtwiderstands Rges:

$$Uges = Iges * Rges$$

- Bilden eines Spannungs-Differenzwertes $U_{Diff}$ zwischen dem berechneten Gesamtspannungsabfall Uges und dem vorgegebenen oder gemessenen Wert der anliegenden Versorgungsspannung Vcc bzw. $U_{Vcc}$:

$$U_{Diff} = U_{Vcc} - Uges$$

- Vergleich des Spannungs-Differenzwertes $U_{Diff}$ mit einem Differenz-Schwellwert $U_{Diff-S}$ und Qualifizierung der vorliegenden Schaltstellungserfassung als fehlerhaft bei Überschreitung des Differenz-Schwellwerts $U_{Diff-s}$ durch den aktuellen Spannungs-Differenzwert $U_{Diff}$ :

$$U_{Diff} - U_{Diff-S} \; <= \; 0 \; \rightarrow \; i.O. \quad ; \quad U_{Diff} - U_{Diff-S} \; > \; 0 \; \rightarrow \; \text{„Fehler"}$$

Diese einfache Variante des erfindungsgemäßen Verfahrens zielt auf die Feststellung von Fehlern ab, die insbesondere in den alle Widerstandszweige gleichermaßen betreffenden, gemeinsamen Zuleitungen auftreten können. Solche Fehler die nur in einem einzelnen der Widerstandszweige auftreten sind mit einer Weiterbildung des erfindungsgemäßen Verfahrens zu erfassen, die auch eine Kompensation dieser Fehler ermöglicht, so dass eine verbesserte Verfügbarkeit der Schalteinrichtung gegeben ist.

Die Verfahrensschritte dieser Weiterbildung des erfindungsgemäßen Verfahrens sind bis zum dritten Schritt identisch mit der zuvor beschriebenen einfacheren Variante, so dass die beiden Verfahren durchaus parallel betrieben werden können. Sie sind wieder beschrieben anhand der gemäß der Zeichnung ausgeführten Form der Schalteinrichtung:

- Erfassen der Messspannungen $U_{M1}$ , $U_{M2}$ in den Widerstandszweigen der den unterschiedlichen Funktionen zugeordneten Schaltelemente SE1, SE2

- Identifizieren der jeweiligen Schaltstellungen durch Vergleich der erfassten Ist-Werte der Messspannungen $U_{M1}$ , $U_{M2}$ mit vorgegebenen, festen Soll-Werten für die verschiedenen Schaltstellungen

- Berechnen der in den jeweiligen Widerstandszweigen fließenden Ströme I1, I2 aus den erfassten Messspannungen $U_{M1}$ , $U_{M2}$ und den Nominalwerten der Messwiderstände M1, M2:

$$I1 = M1 * U_{M1} \quad ; \quad I2 = M2 * U_{M2}$$

- Berechnen der über den jeweiligen Widerstandszweigen abfallenden Zweigspannungsabfälle aus den in diesen fließenden Zweigströmen und den jeweiligen Nominalwerten der Messwiderstände der in den identifizierten Schaltstellungen wirksamen Schaltwiderstände (im dargestellten Beispiel S11, S23):

$$U1 = I1 * (M1 + S11) \quad ; \quad U2 = I2 * (M2 + S23)$$

- Bilden eines Spannungs-Differenzwertes $U_{Diff}$ zwischen dem größten der berechneten Zweigspannungsabfälle Umax und dem vorgegebenen oder gemessenen Wert der anliegenden Versorgungsspannung Vcc bzw. $U_{Vcc}$ :

$$U_{Diff} = U_{Vcc} - Umax \qquad (Umax = max \; von \; U1, \; U2)$$

- Vergleich des Spannungs-Differenzwertes $U_{Diff}$ mit einem Differenz-Schwellwert $U_{Diff-S}$ und Qualifizierung der vorliegenden Schaltstellungserfassung als fehlerhaft bei Überschreitung des Differenz-Schwellwerts $U_{Diff-s}$ durch den aktuellen Spannungs-Differenzwert $U_{Diff}$ :

$$U_{Diff} - U_{Diff-S} \; <= \; 0 \; \rightarrow \; i.O. \quad ; \quad U_{Diff} - U_{Diff-S} \; > \; 0 \; \rightarrow \; \text{„Fehler"}$$

Der Spannungs-Differenzwert $U_{Diff}$ zur anliegenden Versorgungsspannung $U_{Vcc}$ wird immer mit dem größten der berechneten Zweigspannungsabfälle U1, U2 gebildet, da dieser durch die Parallelschaltung der Widerstandszweige das Spannungsniveau aller Zweige festlegt. Geringere Spannungsabfälle in den anderen Zweigen müssen daher durch Störwiderstände innerhalb dieser Zweige verursacht worden sein. Im pathologischen Fall nur eines einzigen Widerstandszweiges ist das zuletzt beschriebene Verfahren mit dem davor beschriebenen, einfacheren identisch.

Zur Kompensation von Störungen und damit zur Korrektur möglicher Messfehler werden in einer vorteilhaften Weiterbildung des Verfahrens die im vorletzten Schritt der zuletzt beschriebenen Abfolge von Verfahrensschritten ermittelten Zweigspannungsabfälle U1, U2 auf die auslegungsgemäße oder gemessene Versorgungsspannung Vcc bzw. $U_{Vcc}$ hochskaliert. Dazu wird für jeden Widerstandszweig ein Skalierungsfaktor SF1, SF2 berechnet, der durch den Quotienten aus dem vorgegebenen Vcc oder gemessenen Wert $U_{Vcc}$ der anliegenden Versorgungsspannung und dem jeweiligen Zweigspannungsabfall U1, U2 gebildet ist:

$$SF1 = U_{Vcc} / U1 \quad ; \quad SF2 = U_{Vcc} / U2$$

Die erfassten Messspannungen $U_{M1}$ , $U_{M2}$ in den jeweiligen Zweigen werden im nächsten Schritt mit den ermittelten Skalierungsfaktoren SF1, SF2 multipliziert und die erhaltenen Ergebnisse wie gehabt mit den vorgegebenen, festen Soll-Werten für die verschiedenen Schaltstellungen verglichen:

$$U_{M1\ skal} = SF1 * U_{M1} \quad ; \quad U_{M2\ skal} = SF2 * U_{M2}$$

Durch die Skalierung sind mögliche Fehlereinflüsse, die Abweichungen der erfassten Messspannungen $U_{M1}$ , $U_{M2}$ von den auslegungsgemäß erwarteten Werten verursachen, kompensiert, so dass eine sicherere Identifikation der tatsächlichen Schaltstellungen mittels der skalierten Messspannungen $U_{M1}$ skal , $U_{M2}$ skal ermöglicht ist.

Durch kontinuierliche Anwendung des beschriebenen Verfahrens während der Schaltstellungserfassung ist eine effektive Überwachung möglicher Störeinflüsse möglich. Der frei definierbare Differenz-Schwellwert $U_{Diff-s}$ kann auch lediglich zur Signalisierung eines Fehlerfalls herangezogen werden, ohne in die Funktion einzugreifen.

Langsame oder phasenweise konstante Widerstandsänderungen können auf Basis des erfindungsgemäßen Verfahrens gut kompensiert werden. Damit steht das gesamte Zustands-Erkennungs-Fenster für sprunghafte Widerstandsänderungen zur Verfügung. Dies steigert deutlich die Verfügbarkeit.

**Patentansprüche**

1. Verfahren zur Erfassung einer Schaltstellung einer zumindest ein Schaltelement (SE1, SE2) umfassenden Schalteinrichtung, wobei die jeweilige Schaltstellung des Schaltelements (SE1, SE2) durch einen Wert einer physikalischen Messgröße ($U_{M1}$ , $U_{M2}$) des Schaltelements repräsentiert ist, die über einen A/D-Wandlereingang (A/D) einem Mikroprozessor ($\mu$C) zur Auswertung zugeführt wird, umfassend die Verfahrensschritte:

   - Identifizieren der Schaltstellung durch Vergleich des erfassten Ist-Wertes der physikalischen Messgröße ($U_{M1}$ , $U_{M2}$) mit vorgegebenen, festen Soll-Werten für die verschiedenen Schaltstellungen
   - Berechnen eines abgeleiteten Wertes einer physikalischen Vergleichsgröße (Uges) für die jeweils identifizierte Schaltstellung mittels eines auf den Nennwerten der die Messgröße ($U_{M1}$ , $U_{M2}$) bestimmenden Bauelemente (M1, M2, S11, S12, S13, S21, S22, S23, S24) und Eingangsgrößen (Uvcc) der Schalteinrichtung basierenden physikalischen Modells der Schalteinrichtung unter Verwendung des erfassten Ist-Wertes der physikalischen Messgröße ($U_{M1}$ , $U_{M2}$)
   - Bilden eines Differenzwertes ($U_{Diff}$) zwischen dem abgeleiteten Wert der physikalischen Vergleichsgröße (Uges) und dem vorgegebenen Nennwert (Vcc) oder einem aktuell erfassten Ist-Wert (Uvcc) der physikalischen Vergleichsgröße
   - Vergleich des Differenzwertes ($U_{Diff}$) mit einem Differenz-Schwellwert ($U_{Diff-S}$) und Qualifizierung der vorliegenden Schaltstellungserfassung als fehlerhaft bei Überschreitung des Differenz-Schwellwerts ($U_{Diff-s}$) durch den aktuellen Differenzwert ($U_{Diff}$)

2. Verfahren nach Anspruch 1, **dadurch gekennzeichnet, dass** bei einer Qualifizierung der vorliegenden Schaltstellungserfassung als fehlerhaft das Auslösen der damit verbundenen Fahrzeugfunktion unterbunden wird.

3. Verfahren nach Anspruch 1 oder 2, **dadurch gekennzeichnet, dass** das zumindest eine Schaltelement (SE1, SE2) der Schalteinrichtung durch einen einerseits mit einem Massepotential (Gnd) verbundenen und andererseits in jeder Schaltstellung über einen dieser Schaltstellung jeweils zugeordneten Schaltwiderstand (S11, S12, S13; S21, S22, S23, S24) mit einer konstanten Versorgungsspannung (Vcc) verbindbaren Messwiderstand (M1, M2) gebildet ist, und dass die physikalische Messgröße die in der jeweiligen Schaltstellung über dem Messwiderstand abfallende Messspannung ($U_{M1}$ , $U_{M2}$) ist.

4. Verfahren nach einem der Ansprüche 1 bis 3, **dadurch gekennzeichnet, dass** die Schalteinrichtung zumindest zwei Schaltelemente (SE1, SE2) umfasst, die jeweils einen Widerstandszweig mit einem Messwiderstand (M1, M2)

und zumindest zwei Schaltwiderständen (S11, S12, S13; S21, S22, S23, S24) umfassen, wobei der eine Anschluss des Messwiderstands (M1, M2) mit einem Massepotential (Gnd) verbunden ist und der andere Anschluss in jeder Schaltstellung über einen dieser Schaltstellung jeweils zugeordneten Schaltwiderstand (S11, S12, S13; S21, S22, S23, S24) mit einer konstanten Versorgungsspannung (Vcc) verbunden wird, wobei die Widerstandszweige parallel zueinander geschaltet, und durch gemeinsame elektrische Leitungen einerseits mit dem Massepotential (Gnd) und andererseits mit der Versorgungsspannung (Vcc) verbunden sind, und wobei die über den Messwiderständen (M1, M2) abfallenden Messspannungen ($U_{M1}$, $U_{M2}$) über A/D-Wandlereingänge (A/D 1, A/D 2) einem Mikroprozessor ($\mu$C) zur Auswertung zugeführt werden, umfassend die Verfahrensschritte:

- Erfassen der Messspannungen (UM1, UM2) in den Widerstandszweigen der den unterschiedlichen Funktionen zugeordneten Schaltelemente (SE1, SE2)
- Identifizieren der jeweiligen Schaltstellungen durch Vergleich der erfassten Ist-Werte der Messspannungen (UM1, UM2) mit vorgegebenen, festen Soll-Werten für die verschiedenen Schaltstellungen
- Berechnen der in den jeweiligen Widerstandszweigen fließenden Zweigströme (I1, I2) aus den erfassten Messspannungen (UM1, UM2) und den Nominalwerten der Messwiderstände (M1, M2)
- Addieren der in den jeweiligen Widerstandszweigen fließenden Zweigströme (I1, I2) zu dem durch alle parallelen Widerstandszweige gemeinsam fließenden Gesamtstrom (Iges)
- Berechnen des durch die Parallelschaltung aller Widerstandszweige gebildeten Gesamtwiderstands (Rges) zwischen dem Massepotential (Gnd) und der Versorgungsspannung (Vcc) aus den Nominalwerten der Messwiderstände (M1, M2) und der in den identifizierten Schaltstellungen wirksamen Schaltwiderstände (S11, S12, S13 ; S21, S22, S23, S24)
- Berechnen des Gesamtspannungsabfalls (Uges) über der Parallelschaltung aller Widerstandszweige aus den berechneten Werten des Gesamtstroms (Iges) und des Gesamtwiderstands (Rges)
- Bilden eines Spannungs-Differenzwertes (UDiff) zwischen dem berechneten Gesamtspannungsabfall (Uges) und dem vorgegebenen oder gemessenen Wert der anliegenden Versorgungsspannung (Vcc ; UVcc)
- Vergleich des Spannungs-Differenzwertes (UDiff) mit einem Differenz-Schwellwert (UDiff-S) und Qualifizierung der vorliegenden Schaltstellungserfassung als fehlerhaft bei Überschreitung des Differenz-Schwellwerts (UDiff-S) durch den aktuellen Spannungs-Differenzwert (U-Diff)

5. Verfahren nach einem der Ansprüche 1 bis 3, **dadurch gekennzeichnet, dass** die Schalteinrichtung zumindest zwei Schaltelemente (SE1, SE2) umfasst, die jeweils einen Widerstandszweig mit einem Messwiderstand (M1, M2) und zumindest zwei Schaltwiderständen (S11, S12, S13; S21, S22, S23, S24) umfassen, wobei der eine Anschluss des Messwiderstands (M1, M2) mit einem Massepotential (Gnd) verbunden ist und der andere Anschluss in jeder Schaltstellung über einen dieser Schaltstellung jeweils zugeordneten Schaltwiderstand (S11, S12, S13; S21, S22, S23, S24) mit einer konstanten Versorgungsspannung (Vcc) verbunden wird, wobei die Widerstandszweige parallel zueinander geschaltet, und durch gemeinsame elektrische Leitungen einerseits mit dem Massepotential (Gnd) und andererseits mit der Versorgungsspannung (Vcc) verbunden sind, und wobei die über den Messwiderständen (M1, M2) abfallenden Messspannungen ($U_{M1}$ $U_{M2}$) über A/D-Wandlereingänge (A/D 1, A/D 2) einem Mikroprozessor ($\mu$C) zur Auswertung zugeführt werden, umfassend die Verfahrensschritte:

- Erfassen der Messspannungen ($U_{M1}$, $U_{M2}$) in den Widerstandszweigen der den unterschiedlichen Funktionen zugeordneten Schaltelemente (SE1, SE2)
- Identifizieren der jeweiligen Schaltstellungen durch Vergleich der erfassten Ist-Werte der Messspannungen ($U_{M1}$, $U_{M2}$) mit vorgegebenen, festen Soll-Werten für die verschiedenen Schaltstellungen
- Berechnen der in den jeweiligen Widerstandszweigen fließenden Zweigströme (I1, I2) aus den erfassten Messspannungen ($U_{M1}$, $U_{M2}$) und den Nominalwerten der Messwiderstände (M1, M2)
- Berechnen der über den jeweiligen Widerstandszweigen abfallenden Zweigspannungsabfälle (U1, U2) aus den in diesen fließenden Zweigströmen (I1, I2) und den jeweiligen Nominalwerten der Messwiderstände (M1, M2) der in den identifizierten Schaltstellungen wirksamen Schaltwiderstände(S11, S12, S13; S21, S22, S23, S24)
- Bilden eines Spannungs-Differenzwertes ($U_{Diff}$) zwischen dem größten der berechneten Zweigspannungsabfälle (Umax) und dem vorgegebenen oder gemessenen Wert der anliegenden Versorgungsspannung (Vcc; $U_{Vcc}$)
- Vergleich des Spannungs-Differenzwertes ($U_{Diff}$) mit einem Differenz-Schwellwert ($U_{Diff-S}$) und Qualifizierung der vorliegenden Schaltstellungserfassung als fehlerhaft bei Überschreitung des Differenz-Schwellwerts ($U_{Diff-s}$) durch den aktuellen Spannungs-Differenzwert ($U_{Diff}$)

6. Verfahren nach Anspruch 5, **dadurch gekennzeichnet, dass** bei einer Qualifizierung der vorliegenden Schaltstellungserfassung als fehlerhaft die folgenden weiteren Verfahrensschritte durchlaufen werden:

- Berechnung jeweils eines Skalierungsfaktors (SF1, SF2) für jeden Widerstandszweig als Quotient aus dem vorgegebenen oder gemessenen Wert der anliegenden Versorgungsspannung (Vcc; $U_{Vcc}$) und dem jeweiligen Zweigspannungsabfall (U1, U2)

- Bilden skalierter Messspannungswerte ($U_{M1}$ skal , $U_{M2}$ skal) als Produkt der erfassten Messspannung Messspannungen ($U_{M1}$ , $U_{M2}$)mit dem berechneten Skalierungsfaktor (SF1, SF2) für den jeweiligen Widerstandszweig

- Neu-Identifizieren der jeweiligen Schaltstellungen durch Vergleich der skalierten Messspannungswerte ($U_{M1}$ skal , $U_{M2}$ skal) mit den vorgegebenen, festen Soll-Werten für die verschiedenen Schaltstellungen

**7.** Verfahren nach einem der vorhergehenden Ansprüche, **dadurch gekennzeichnet, dass** die Verfahrensschritte in einer kontinuierlich ablaufenden Schleife immer wiederholt durchlaufen werden.

**Claims**

**1.** Process for acquiring a switch position of a switching mechanism comprising at least one switching element (SE1, SE2), whereby the relevant switch position of the switching element (SE1, SE2) is reprevailinged by a value of a physical measured quantity ($U_{M1}$, $U_{M2}$) of the switching element which is conveyed via an A/D converter input (A/D) to a microprocessor ($\mu$C) for analysis purposes, comprising the process steps:

- Identification of the switch position by comparing the acquired actual value of the physical measured quantity ($U_{M1}$, $U_{M2}$) with predetermined, fixed set-point values for the individual switch positions,
- Calculation of a derived value of a physical comparison value (Uges) for the respectively identified switch position by means of a physical model of the switching mechanism based on the nominal values of the components (M1, M2, S11, S12, S13, S21, S22, S23, S24) and input variables ($U_{Vcc}$) of the switching mechanism that determine the measured quantity ($U_{M1}$, $U_{M2}$), while utilising the acquired actual value of the physical measured quantity ($U_{M1}$, $U_{M2}$),
- Formation of a differential value ($U_{Diff}$) between the derived value of the physical comparison value (Uges) and the predetermined nominal value (Vcc) or a currently acquired actual value ($U_{Vcc}$) of the physical comparison value,
- Comparison of the differential value ($U_{Diff}$) with a differential threshold value ($U_{Diff-s}$) and qualification of the prevailing switch position acquisition as incorrect if the differential threshold value ($U_{Diff-S}$) is exceeded by the current differential value ($U_{Diff}$).

**2.** Process according to Claim 1, **characterised in that** in the event of the prevailing switch position acquisition being qualified as incorrect, the triggering of the vehicle function linked to the same is stopped.

**3.** Process according to Claim 1 or Claim 2, **characterised in that** the at least one switching element (SE1, SE2) of the switching mechanism is formed by a measuring resistor (M1, M2) that is connected to a ground potential (Gnd) on the one hand and can be connected in each switch position to a constant supply voltage (Vcc) via a switching resistor (S11, S12, S13; S21, S22, S23, S24) allocated, respectively, to this switch position on the other hand, and that the physical measured quantity is the measuring voltage ($U_{M1}$, $U_{M2}$) released by way of the measuring resistors in the respective switch position.

**4.** Process according to any of Claims 1 to 3, **characterised in that** the switching mechanism comprises at least two switching elements (SE1, SE2), each of which is made up of a resistance branch with a measuring resistor (M1, M2) and at least two switching resistors (S11, S12, S13; S21, S22, S23, S24), whereby the one terminal of the measuring resistor (M1, M2) is connected to a ground potential (Gnd) and the other terminal is connected in each switch position to a constant supply voltage (Vcc) via a switching resistor (S11, S12, S13; S21, S22, S23, S24) allocated respectively to this switch position, whereby the resistance branches are connected to each other in parallel and are connected by common electric lines to the ground potential (Gnd) on the one hand and to the supply voltage (Vcc) on the other hand, and whereby the measuring voltages ($U_{M1}$, $U_{M2}$) released by way of the measuring resistors (M 1, M2) are conveyed via A/D converter inputs (A/D 1, A/D 2) to a microprocessor ($\mu$C) for analysis purposes, comprising the process steps:

- Acquisition of the measuring voltages (UM1, UM2) in the resistance branches of the switching elements (SE1, SE2) allocated to the different functions,
- Identification of the respective switch positions by comparing the acquired actual values of the measuring voltages (UM1, UM2) with predetermined, fixed set-point values for the individual switch positions,

- Calculation of the branch currents (I1, I2) from the acquired measuring voltages (UM1, UM2) flowing into the respective resistance branches and the nominal values of the measuring resistors (M1, M2),

- Addition of the branch currents (I1, I2) flowing into the relevant resistance branches to the total current (Iges) flowing collectively through all the parallel resistance branches,

- Calculation of the total resistance (Rges) formed by the parallel connection of all resistance branches between the ground potential (Gnd) and the supply voltage (Vcc) from the nominal values of the measuring resistors (M1, M2) and the switching resistors (S11, S12, S13; S21, S22, S23, S24) that are operative in the identified switch positions,

- Calculation of the total voltage drop (Uges) across the parallel connection of all resistance branches from the calculated values of the total current (Iges) and the total resistance (Rges),

- Formation of a voltage differential value (UDiff) between the calculated total voltage drop (Uges) and the predetermined or measured value of the applied supply voltage (Vcc ; UVcc),

- Comparison of the voltage differential value (UDiff) with a differential threshold value (UDiff-S) and qualification of the prevailing switch position acquisition as incorrect if the differential threshold value (UDiff-S) is exceeded by the current voltage differential value (U-Diff).

5. Process according to any of Claims 1 to 3, **characterised in that** the switching mechanism comprises at least two switching elements (SE1, SE2), each of which is made up of a resistance branch with a measuring resistor (M1, M2) and at least two switching resistors (S11, S12, S13; S21, S22, S23, S24), whereby the one terminal of the measuring resistor (M1, M2) is connected to a ground potential (Gnd) and the other terminal is connected in each switch position to a constant supply voltage (Vcc) via a switching resistor (S11, S12, S13; S21, S22, S23, S24) allocated respectively to this switch position, whereby the resistance branches are connected in parallel to each other and are connected by common electric lines to the ground potential (Gnd) on the one hand and to the supply voltage (Vcc) on the other hand, and whereby the measuring voltages ($U_{M1}$, $U_{M2}$) released by way of the measuring resistors (M1, M2) are conveyed via A/D converter inputs (A/D 1, A/D 2) to a microprocessor ($\mu$C) for analysis purposes, comprising the process steps:

- Acquisition of the measuring voltages ($U_{M1}$, $U_{M2}$) in the resistance branches of the switching elements (SE1, SE2) allocated to the different functions,

- Identification of the respective switch positions by comparing the acquired actual values of the measuring voltages ($U_{M1}$, $U_{M2}$) with predetermined, fixed set-point values for the individual switch positions,

- Calculation of the branch currents (I1, I2) from the acquired measuring voltages ($U_{M1}$, $U_{M2}$) flowing into the relevant resistance branches and the nominal values of the measuring resistors (M1, M2),

- Calculation of the branch voltage drops (U1, U2) released across each of the resistance branches from the branch currents (I1, I2) flowing into the same and the relevant nominal values of the measuring resistors (M1, M2) of the switching resistors (S11, S12, S13; S21, S22, S23, S24) that are operative in the identified switch positions,

- Formation of a voltage differential value ($U_{Diff}$) between the greatest of the calculated branch voltage drops (Umax) and the predetermined or measured value of the applied supply voltage (Vcc ; $U_{Vcc}$),

- Comparison of the voltage differential value ($U_{Diff}$) with a differential threshold value ($U_{Diff-s}$) and qualification of the prevailing switch position acquisition as incorrect if the differential threshold value ($U_{Diff-S}$) is exceeded by the current voltage differential value ($U_{Diff}$).

6. Process according to Claim 5, **characterised in that** the following further process steps are run through once the prevailing switch position acquisition qualifies as incorrect:

- Calculation of a respective scaling factor (SF1, SF2) for each resistance branch as a quotient from the predetermined or measured value of the applied supply voltage (Vcc; UVcc) and the branch voltage drop (U1, U2) in each case,

- Formation of scaled measuring voltage values ($U_{M1}$ skal, $U_{M2}$ skal) as a product of the acquired measuring voltages ($U_{M1}$, $U_{M2}$) with the calculated scaling factor (SF1, SF2) for the relevant resistance branch,

- Re-identification of the respective switch positions by comparing the scaled measuring voltage values ($U_{M1}$ skal, $U_{M2}$ skal) with the predetermined, fixed set-point values for the individual switch positions.

7. Process according to any of the preceding claims, **characterised in that** the process steps are repeatedly run through in a continuously running loop.

**Revendications**

1. Procédé de détection d'une position de commutation d'un dispositif de commutation comprenant au moins un élément de commutation (SE1, SE2), sachant que chaque position de commutation de l'élément de commutation (SE1, SE2) est représentée par une valeur d'une grandeur de mesure physique ($U_{M1}$, $U_{M2}$) qui, pour l'évaluation, est conduite à un microprocesseur ($\mu$C), par l'intermédiaire d'une entrée de convertisseur analogique-numérique (A/D), ledit procédé comprenant les étapes suivantes :

   - Identification de la position de commutation par comparaison de la valeur de la grandeur de mesure physique ($U_{M1}$, $U_{M2}$) saisie avec des valeurs de consigne fixes, prédéterminées pour les différentes positions de commutation,
   - calcul d'une valeur dérivée d'une grandeur de comparaison physique (Uges) pour chacune des positions de commutation identifiées, au moyen d'un modèle physique, basé sur les valeurs nominales des éléments (M1, M2, S11, S12, S13, S21, S22, S23, S24) déterminant les valeurs de la grandeur de mesure physique ($U_{M1}$, $U_{M2}$), en utilisant la valeur réelle de grandeur de mesure physique ($U_{M1}$, $U_{M2}$) détectée,
   - formation d'une valeur de différence ($U_{Diff}$) entre la valeur dérivée de la grandeur de comparaison physique (Uges) et la valeur nominale, prédéterminée (Vcc) ou une valeur réelle actuellement détectée ($U_{Vcc}$) de la grandeur de comparaison physique,
   - comparaison de la valeur de différence ($U_{Diff}$) avec une valeur de seuil de différence ($U_{Diff-S}$) et qualification de la présente détection de positions de commutation comme étant erronée, quand la valeur de seuil de différence ($U_{Diff-S}$) est dépassée par la valeur de différence ($U_{Diff}$). actuelle.

2. Procédé selon la revendication 1, **caractérisé en ce que**, lors d'une qualification de la présente détection de positions de commutation comme étant erronée, le déclenchement de la fonction du véhicule automobile y associée est empêchée.

3. Procédé selon revendication 1 ou 2, **caractérisé en ce que** l'élément de commutation (SE1, SE2) du dispositif de commutation au moins prévu est formé par une résistance de mesure (M1, M2), qui, d'une part, est reliée à un potentiel de masse (Gnd) et, d'autre part, peut être raccordée, dans chaque position de commutation, à une tension d'alimentation constante (Vcc), par l'intermédiaire d'une résistance de commutation (S11, S12, S13 ; S21, S22, S23, S24) associée à la position de commutation respective, et que la grandeur de mesure physique est la tension de mesure sur la résistance de mesure, dans la position de commutation respective.

4. Procédé selon l'une des revendications 1 à 3, **caractérisé en ce que** le dispositif de commutation comprend au moins deux éléments de commutation (SE1, SE2) qui comprennent chacun une branche à résistance avec une résistance de mesure (M1, M2) et au moins deux résistances de commutation (S11, S12, S13 ; S21, S22, S23, S24), sachant que l'un des raccords de la résistance de mesure (M1, M2) est relié à un potentiel de masse (Gnd) et que l'autre raccord est relié, dans chaque position de commutation, à une tension d'alimentation constante (Vcc), par l'intermédiaire d'une résistance de commutation (S11, S12, S13 ; S21, S22, S23, S24) associée à la position de commutation respective, les branches à résistance étant commutées en parallèle les unes par rapport aux autres, et raccordées, d'une part, au potentiel de masse (Gnd) et, d'autre part, à la tension d'alimentation (Vcc), par l'intermédiaire de conduites électriques communes, et sachant que les tensions de mesures ($U_{M1}$, $U_{M2}$), sur les résistances de mesure (M1, M2) sont conduites, aux fins d'évaluation, à un microprocesseur ($\mu$C), par l'intermédiaire d'entrées d'un convertisseur analogique-numérique (A/D1, AD2), ledit procédé comprenant les étapes suivantes :

   - Saisie des tensions de mesure ($U_{M1}$, $U_{M2}$) dans les branches à résistance des éléments de commutation (SE1, SE2) associés aux différentes fonctions
   - identification des positions de commutation respectives par comparaison des valeurs réelles des tensions de mesure détectées ($U_{M1}$, $U_{M2}$) avec des valeurs de consigne fixes, prédéterminées pour les différentes positions de commutation,
   - calcul des courants (I1, I2) s'écoulant dans les branches à résistance respectives, à partir des tensions de mesure détectées ($U_{M1}$, $U_{M2}$) et des valeurs nominales des résistances de mesure (M1, M2),
   - addition des courants (I1, I2) s'écoulant dans les branches à résistance respectives et du courant total, commun (Iges) traversant toutes les branches à résistance parallèles,
   - calcul de la résistance totale (Rges), formée, par la commutation en parallèle de toutes les branche à résistances, entre le potentiel de masse (Gnd) et la tension d'alimentation (Vcc), à partir des valeurs nominales des résistances de mesure (M1, M2), et des résistances de commutation (S11, S12, S13 ; S21, S22, S23, S24) effectives dans les positions de commutation identifiées,

- calcul de la tension totale (Uges) sur la commutation en parallèle de toutes les branches à résistance à partir des valeurs calculées du courant total (Iges) et de la résistance totale (Rges),
- formation d'une valeur de différence ($U_{Diff}$) entre la tension totale (Uges) calculée et la valeur prédéterminée ou mesurée de la tension d'alimentation appliquée (Vcc ; UVcc),
- comparaison de la valeur de différence de tension (UDiff) avec une valeur de seuil de différence (UDiff-S) et qualification de la présente détection de positions de commutation comme étant erronée, quand la valeur de seuil de différence (UDiff-S) est dépassée par la valeur de différence (UDiff).

5. Procédé selon l'une des revendications 1 à 3, **caractérisé en ce que** le dispositif de commutation comprend au moins deux éléments de commutation (SE1, SE2) qui comprennent chacun une branche à résistance avec une résistance de mesure (M1, M2) et au moins deux résistances de commutation (S11, S12, S13 ; S21, S22, S23, S24), sachant que l'un des raccords de la résistance de mesure (M1, M2) est relié à un potentiel de masse (Gnd) et que l'autre raccord est relié, dans chaque position de commutation, à une tension d'alimentation constante (Vcc), par l'intermédiaire d'une résistance de commutation (S11, S12, S13 ; S21, S22, S23, S24) associée à la position de commutation respective, les branche à résistances à résistance étant commutées en parallèle les unes par rapport aux autres, et raccordées, d'une part, au potentiel de masse (Gnd) et, d'autre part, à la tension d'alimentation (Vcc), par l'intermédiaire de conduites électriques communes, et sachant que les tensions de mesure ($U_{M1}$, $U_{M2}$) sur les résistances de mesure (M1, M2) sont conduites à un microprocesseur ($\mu$C), par l'intermédiaire d'entrées d'un convertisseur analogique-numérique (A/D 1, A/D 2), pour l'évaluation, ledit procédé comprenant les étapes suivantes :

- Saisie des tensions de mesure ($U_{M1}$, $U_{M2}$) dans les branches à résistance des éléments de commutation (SE1, SE2) associés aux différentes fonctions
- identification des positions de commutation respectives par comparaison des valeurs réelles des tensions de mesure ($U_{M1}$, $U_{M2}$) saisies avec des valeurs de consigne fixes, prédéterminées pour les différentes positions de commutation,
- calcul des courants ((I1, I2) dans les branches à résistance respectives, à partir des valeurs de tension de mesure ($U_{M1}$, $U_{M2}$) détectées et les valeurs nominales respectives des résistances de mesure (M1, M2),
- calcul des tensions (U1, U2) sur les branches à résistance respectives, à partir des courants (I1, I2) dans les branches à résistance respectives et les valeurs nominales des résistances de mesure (M1, M2) des résistances de commutation (S11, S12, S13 ; S21, S22, S23, S24) efficaces dans les positions de commutation identifiés,
- formation d'une valeur de différence de tension ($U_{Diff}$) entre la plus grande (Umax) des tensions calculées sur les branches à résistance et la valeur prédéterminée ou mesurée de la tension d'alimentation appliquée (Vcc ; UVcc),
- comparaison de valeur de différence de tension ($U_{Diff}$) avec une valeur de seuil de différence ($U_{Diff-S}$) et qualification de la présente détection de positions de commutation comme étant erronée, quand la valeur de seuil de différence ($U_{Diff-S}$) est dépassée par la valeur de différence de tension ($U_{Diff}$) actuelle.

6. Procédé selon la revendication 5, **caractérisé en ce que** d'autres étapes sont effectuées quand la présente détection de position de commutation est qualifiée d'erronée, lesdites autres étapes étant les suivantes:

- Calcul d'un facteur de mise à l'échelle (SF1, SF2) respectif pour chaque branche à résistance en tant que quotient de la valeur prédéterminée ou mesurée de la tension d'alimentation appliquée (Vcc ; Uvcc) et de la tension respective des branches à résistance (U1, U2),
- formation de valeurs de mesure de tension mises à l'échelle ($U_{M1-skal}$, $U_{M2-skal}$) en tant que produit des tensions de mesure détectées ($U_{M1}$, $U_{M2}$) avec le facteur de mise à l'échelle (SF1, SF2) calculé pour la branche à résistance respective,
- nouvelle identification des positions de commutation respectives par comparaison des valeurs de tensions de mesure mises à l'échelle ($U_{M1\ skal}$, $U_{M2\ skal}$) avec les valeurs de consigne fixes prédéterminées pour les différentes positions de commutation.

7. Procédé selon l'une des revendications précédentes, **caractérisé en ce que** les étapes du procédé sont réitérées en boucle continue.

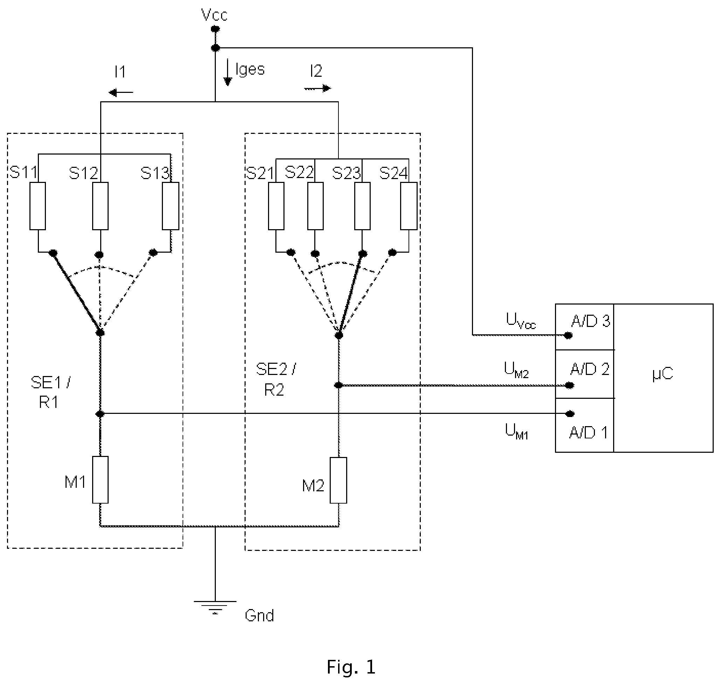

Fig. 1

**IN DER BESCHREIBUNG AUFGEFÜHRTE DOKUMENTE**

**In der Beschreibung aufgeführte Patentdokumente**

- DE 102008044115 A1
- DE 102008007650 A1